# EUROPÄISCHE PATENTSCHRIFT

(11) **EP 1 333 013 B1**
(45) Veröffentlichungstag und Bekanntmachung des Hinweises auf die Patenterteilung: **27.07.2011**
(21) Anmeldenummer: 02027226.6
(22) Anmeldetag: 06.12.2002
(51) Int. Cl.: C04B 35/536, C30B 15/10

(54) **Materialien für und Herstellung von hochreinen Verschleisseinlagen**
High purity wear resistant inlay material and its production method
Matériaux d'insertion résistant à l'usure et de haute pureté et son procédé de fabrication

(30) Priorität: 05.02.2002 DE 10204468
(43) Veröffentlichungstag der Anmeldung: 06.08.2003
(73) Patentinhaber: SGL Carbon SE, 65203 Wiesbaden (DE)
(72) Erfinder: Kahl, Hans-Georg, 53359 Rheinbach (DE); Kessel, Jürgen, Dipl.-Ing., 53604 Bad Honnef (DE); Schmitz-Graepp, Helmut, Dipl.-Ing., 53177 Bonn (DE)

(56) Entgegenhaltungen:
- WO-A-98/48085
- DD-A1- 131 640
- DE-A1- 4 007 053
- JP-A- 4 021 509

## Beschreibung

Gegenstand der Erfindung ist ein Verfahren zum Herstellen einer hochreinen ersetzbaren Verschleißeinlage aus expandiertem Graphit ohne oder mit Additiven aus Kohlenstoff- oder Graphit wie z.B. textilen Kohlenstofffaserprodukten zum Schutze von graphitierten Stütztiegeln vor reaktivem Angriff durch Quarzglastiegel bei Prozessen der Halbleitertechnik mit Temperaturen über 500 °C.

Beim Herstellen und Verarbeiten von sehr reinen Materialien, wie sie z.B. in der Halbleiterindustrie benötigt werden, werden in vielen Fällen hohe Temperaturen angewandt. Dementsprechend müssen die Hilfsmittel, welche dafür verwendet werden, hoch rein und vor allem ebenfalls hoch temperaturbeständig sein. Ein Werkstoff, der diese Anforderungen bestens erfüllt ist Graphit. Ein Nachteil von Graphitteilen, die derartigen Bedingungen standhalten müssen, ist jedoch ihre begrenzte Standzeit, die auf den Angriff von chemisch aktiven, meist gasförmigen Substanzen wie beispielsweise Sauerstoff, Siliziummonoxid, Kohlendioxid oder auch von festem oder hochviskosem Siliciumdioxid bei den herrschenden hohen Temperaturen zurückzuführen ist. Diese begrenzte Standzeit schlägt sich auch im Aufwand für die jeweils durchgeführten Prozesse, z.B. beim Ziehen von Silicium-Einkristallen und den dabei verwendeten und direkt mit Graphit im Kontakt befindlichen Quarzglastiegeln negativ nieder.

Bei den hohen angewandten Temperaturen sind die Quarzglastiegel mechanisch nicht mehr genügend stabil und bedürfen, um ihre Form zu behalten, einer Stützung. Für diese Stützfunktion dienen Tiegel aus einem speziellen Reinstgraphit, die unter diesen Bedingungen noch vollständig formstabil sind.

Es hat nicht an Ansätzen gefehlt, Graphitwerkstoffe und daraus hergestellter Bauteile - auch mit zusätzlichen Schichten - für die vorbeschriebenen Verwendungszwecke zu entwickeln, um die Standzeit so hergestellter Bauteile und Einrichtungen zu verbessern. Dies betrifft insbesondere Stütztiegel aus Graphit - auch mit schützenden Schichten.

Ein möglicher Weg wird in WO 98/48085 beschrieben. Materialschichten zwischen dem Quarzglastiegel und dem graphitierten Stütztiegel sollen Reaktionen dieser beiden Tiegel(materialien) miteinander unterbinden. Solche Schichten sind aus hochschmelzenden Metallen, deren Carbiden, Oxiden oder Siliciden aufgebaut. Die Schichten werden auf den Graphit aufgebracht. Die thermodynamischen Reaktionsraten der verschiedenen Reaktionspartner werden detailliert dargestellt.

Ein anderer Weg wurde mit der Beschichtung gängiger Graphitsorten mit kohlenstofffaserverstärktem Kohlenstoff (CFC) beschritten. In DE 40 07 053 A1 wird das Auskleiden von Graphitstütztiegeln aus zwei oder mehr Segmenten beschrieben, die dadurch gekennzeichnet sind, dass sie auf ihrer - dem Quarzglastiegel zugewandten - Innenfläche, dem oberen Rand und an den Berührungsflächen der Segmente jeweils mit einer Schutzschicht aus CFC versehen sind.

Es zeigt sich jedoch, dass so hergestellte Produkte /Tiegel in der Praxis nicht eingesetzt werden.
Nach WO 98/48085 sind zusätzliche Apparaturen zur Herstellung der Schichten, die außerdem gleichmäßig aufzubringen sind, notwendig. Außerdem werden nach diesem Verfahren Metalle in das bezüglich seiner Reinheitsanforderungen überaus sensible Kristallziehsystem eingebracht, die die Siliciumeinkristalle in unerwünschter Weise dotieren und zu minderer oder nicht tolerabler Qualität der Siliciumeinkristalle führen.
Im Falle der DE 40 07 053 A1 hat das CFC dem reaktiven Angriff des Quarzglastiegels nicht besser standgehalten als die gängigen Graphitsorten wobei die Kosten des CFC beträchtlich sind.

Die Herstellkosten der hochreinen, auch beschichteten Teile aus Graphit und der auf diese Teile zurückgehende betriebliche Aufwand, der beispielsweise aus der Standzeit der Stütztiegel beim Kristallziehen resultiert, sind eine beachtenswerte Größe bei den Verfahren, bei denen sie eingesetzt werden. Wenn es gelänge, die Standzeit derartiger, hochwertiger Graphitteile im Geschehen z.B. des Czochralski-Prozesses zu verlängern, läge darin ein beachtlicher technischer und betrieblicher Nutzen.

Mit dem oben zitierten Stand der Technik wird gezeigt, dass direkt auf den Stütztiegeln haftende Schichten realisierbar sind, dass aber solche Schichten den betrieblichen Anforderungen z.B. beim Kristallziehen noch nicht genügen.

Beschichtungen auf den Quarzglastiegeln, die die Aufgabe der Verminderung des reaktiven Angriffes der graphitierten Stütztiegel haben, sind nicht bekannt. Dies ist vermutlich auf mehrere Gründe zurückzuführen: 1. Es ist in den Schichten eine hohe Reinheit zu erreichen und die verwendeten Materialien dürfen weder die Quarzglastiegel noch die darin zu behandelnde Siliciumschmelze dotieren. 2. Die Herstellprozesse für solche Schichten auf den Quarzglastiegeln erfordern einen beträchtlichen Aufwand, siehe die oben im Zusammenhang mit graphitierten Stütztiegeln zitierte Schrift WO 98/48085.
3. Da sich die Quarzglastiegel bei den hohen Temperaturen während des Kristallziehens unter der Last der Siliciumschmelze verformen, ist nicht ohne weiteres zu erwarten, dass eine Beschichtung auf den Quarzglastiegeln diese Verformung mitmachen. Vielmehr ist zu erwarten, dass eine Beschichtung dann reißen wird. Damit ist der Schutz des Quarzglastiegels zumindest partiell nicht mehr gewährleistet.
Wenn weder auf dem Untergrund "graphitierter Stütztiegel" noch auf dem Untergrund "Quarzglastiegel" festhaftende Schutzschichten zu befriedigenden Resultaten bezüglich des reaktiven Angriffes des graphitierten Stütztiegels durch den Quarzglastiegel geführt haben, dann ist nach einer geeigneten, dünnen, von den Untergründen unabhängigen Zwischenlage oder nach einem geeigneten, dünnen Zwischentiegel zu suchen. Diese Suche gliedert sich in zwei wesentliche Abschnitte:
1. Finden geeigneter Werkstoffe und 2. Entwickeln eines geeigneten Herstellungsverfahrens.

Es war eine der Aufgaben der vorliegenden Erfindung, einen Werkstoff, Werkstoffe oder Werkstoffgruppen für nicht fest mit dem graphitierten Stütztiegel oder mit dem Quarzglastiegel verbundene Schichten zu finden, die als Werkstoffe und in Form von dünneren, reaktionshemmenden Schichten die Anforderungen der Prozesse in der Halbleitertechnik erfüllen.

Eine andere Aufgabe bestand darin, ein Verfahren zum Herstellen einer hochreinen ersetzbaren Verschleißeinlage aus expandiertem Graphit aufzuzeigen. Additive zum expandierten Graphit aus Kohlenstoff- oder Graphit wie z.B. textilen Kohlenstofffaserprodukten können dabei von Vorteil sein.

Die Suche nach einem Werkstoff oder einer Werkstoffgruppe wird durch mehrere Anforderungen bestimmt:
1. Der Werkstoff oder die Werkstoffgruppe darf keine Fremdoder Dotierungselemente in den (Hochtemperatur-)Prozess der Halbleitertechnik einbringen.
2. Der Werkstoff oder die Werkstoffgruppe darf den Verschleiß (die Oxidation oder die Reduktion) der eingeführten, nützlichen Komponenten des (Hochtemperatur-)Prozesses der Halbleitertechnik (Quarzglastiegel und Graphitstütztiegel) nicht erhöhen.
3. Es muss erkennbar sein, dass der Werkstoff oder die Werkstoffgruppe in dünnen Schichten und zu einem ökonomisch vertretbaren Aufwand hergestellt werden kann.
4. Der Werkstoff oder die Werkstoffgruppe muss solche Schichten ergeben, die die Reaktionen zwischen Quarzglastiegel und Graphitstütztiegel hemmen.
5. Quarzglastiegel für die Prozesse der Halbleitertechnik haben äußere Durchmesser in der Größenordnung von 70 cm. Folglich müssen auch die dünnen Schichten aus dem identifizierten Werkstoff oder der identifizierten Werkstoffgruppe in dieser Größe machbar und handhabbar sein.

Die erste Anforderung schränkt die Zahl der möglichen Werkstoffe ganz erheblich ein. So wird man vermeiden, z.B. Oxide, wie dies in WO 98/48085 vorgeschlagen wird, Carbide oder Nitride von hochschmelzenden Metallen zu verwenden, weil diese Metalle auch als Dotierungselement für das Halbleitermaterial in Frage kommen.
Zweckmäßigerweise wird man solche Werkstoffe verwenden, die schon bisher in den Prozessen der Halbleitertechnik vorkommen, nämlich Kohlenstoff, Silicium und Sauerstoff.

Einige Werkstoffe aus den genannten Elementen Kohlenstoff, Silicium und Sauerstoff, erfüllen die zweite Anforderung weitgehend. Andere kommen nicht in Frage: Ein hochreaktives Material aus den Elementen Silicium und Sauerstoff, nämlich Siliciummonoxid, ist auszuschließen, weil diese Verbindung bei einer Temperatur von über 1200 °C, die bei den Halbleiterprozessen überschritten wird, gasförmig vorliegt. Kohlenstoff-Sauerstoff-Verbindungen scheiden ebenfalls wegen ihres gasförmigen Zustandes aus. Werkstoffe aus Kohlenstoff und Kohlenstoff-Silicium-Verbindungen sind näher zu betrachten.

Zur dritten Anforderung:

Gruppe A) Werkstoffe auf der Basis von Kohlenstofffasern eignen sich generell zur Herstellung von dünnwandigen, gut handhabbaren Bauteilen. Die Skala der Kilogrammpreise für solche Werkstoffe ist wegen sehr stark differenzierter Veredelungsgrade der Kohlenstofffaser-Produkte außerordentlich breit.
Gruppe B) Werkstoffe auf der Basis von Folien aus expandiertem Graphit eignen sich ebenfalls generell zur Herstellung von dünnwandigen, gut handhabbaren Bauteilen. Hier ist die Veredelungstiefe der Werkstoffe und Produkte sehr viel geringer und der Rohstoff - Naturgraphit geeigneter Qualität - etwa um den Faktor zehn preiswerter als eine Kohlenstofffaser, die die Basis der Werkstoffe der Gruppe A) ist.
Gruppe C) Andere gängige Kohlenstoffe oder Graphittypen eignen sich zur Herstellung dünner Schichten nicht. Diese Werkstoffe sind zu den Keramiken zu rechnen, deren kennzeichnendes Merkmal die Sprödigkeit ist. Entsprechend würden größere, flächige Bauteile, Schalen oder Tiegel bei schon geringerer mechanischer Belastung - möglicherweise schon bei der Herstellung - zerbrechen. Gleiches gilt für seltene Modifikationen des Kohlenstoffes, wie z.B. Pyrokohlenstoff.
Gruppe D) Werkstoffe auf der Basis von Kohlenstoff und Silicium, insbesondere Siliciumcarbid, zählen ebenfalls zu den Keramiken, womit das oben zur Sprödigkeit Gesagte gilt. Mit der Entwicklung und Verwendung einer neuen Klasse von Werkstoffen könnte das Hindernis der Sprödigkeit umgangen werden: mit kohlenstofffaser-verstärktem Siliciumcarbid (CSiC). Allerdings ist der Aufwand zur Herstellung von (dünnwandigen) Teilen aus CSiC heute noch ungewöhnlich hoch, so dass sich der Einsatz dieser Werkstoffklasse für die vorliegenden Aufgabenstellungen aus wirtschaftlichen Gründen nicht empfiehlt.

Zur vierten Anforderung:

Die oben genannte Gruppe A) ist eine sehr vielfältige Gruppe von Werkstoffen. Sie reicht von Filzen über Vliese, Bänder, Gewebe oder Gestricke bis zu dem oben im Zusammenhang mit DE 40 07 053 A1 beschriebenen CFC. Nun hat sich in Vorversuchen gezeigt, dass Filze neben ihrer durch die Art der Fasern bzw. des Bindemittels bedingten geringen Oxidationsbeständigkeit die Reaktionen zwischen Quarzglastiegel und graphitiertem Stütztiegel zu wenig hemmen. Analysen zeigten, dass Zersetzungsprodukte des Quarzglastiegels bei Verwendung von Filzen als Verschleißeinlage im Porensystem des Stütztiegels zu finden sind. Gleiches gilt für Vliese, Bänder, Gewebe oder Gestricke aus Kohlenstofffasern. Argumente zu CFC werden im folgenden Abschnitt zur fünften Anforderung behandelt. Wegen der Erkenntnis der zu geringen Hemmung der Verschleißreaktionen des graphitierten Stütztiegels scheidet die Gruppe A) aus. Die Gruppe B) der Werkstoffe auf der Basis von Folien aus expandiertem Graphit eignet sich im Prinzip, da die Folien je nach Verdichtungsgrad so dicht sind, dass sie eine Permeation von Zersetzungsprodukten des Quarzglastiegels zum graphitierten Stütztiegel hin unterbinden können.
Die Gruppen C) und D) werden nicht weiter betrachtet, da sie die vierte Anforderung nicht ausreichend erfüllen.

### Zur fünften Anforderung:

### Gruppe A):

In der oben zitierten Schrift DE 40 07 053 A1 wurde ein Werkstoff auf der Basis von Kohlenstofffasern, nämlich CFC als fest mit dem graphitierten Stütztiegel verbundene Schicht beschrieben. CFC ist zweifellos geeignet, große, dünnwandige, feste und damit gut handhabbare freitragende Schichten und Bauteile ohne stützenden Untergrund zu erzeugen. Allerdings ist die Oxidationsbeständigkeit von CFC auf Grund der Art des Kohlenstoffbinders geringer als diejenige von speziell gezüchteten Feinkorn-Elektrographiten. Der hohe Kilogrammpreis von CFC von etwa dem zehn- bis fünfzigfachen des Preises der Feinkorn-Elektrographite spricht gegen die Verwendung von CFC als Verschleißeinlage. Hinzu kommt das Argument gemäß der vierten Anforderung, wonach die Werkstoffe auf der Basis von Kohlenstofffasern die Verschleißreaktionen des graphitierten Stütztiegels wegen Permeation von Zersetzungsprodukten des Quarzglastiegels zum graphitierten Stütztiegel hin zu wenig unterbinden. Dies gilt auch für CFC, denn CFC hat je nach Verdichtungsgrad eine hohe offene Porosität, die zwar geringer ist als die der anderen Faserprodukte wie Filze, Vliese usw. aber deutlich höher als z.B. die der üblichen Elektrographite.

### Gruppe B):

Es gehört zum Stand der Technik, aus Folie aus expandiertem Graphit auch relativ große, dünnwandige, selbsttragende Teile zu fertigen. Artikel aus der Dichtungstechnik, wie z.B. Flachdichtungen, werden mit Außendurchmessern zwischen z.B. 20 mm und 1500 mm als Massenprodukte gefertigt. Die verwendeten Werkstoffe sind entweder reiner expandierter Graphit oder Werkstoffkombinationen aus expandiertem Graphit mit Blechen und/oder Kunststoffen.

Die Anforderungen der Prozesse in der Halbleitertechnik erfüllen z.B. wegen der thermischen Beständigkeit nur die Werkstoffe, die nur aus expandiertem Graphit bestehen. Räumlich geformte Teile sind gemessen an den oben genannten Massenprodukten vergleichsweise selten.

Folgende Werkstoffgruppen erfüllen die fünf genannten Anforderungen:
- Werkstoffe auf der Basis von expandiertem Graphit und
- einige Werkstoffe auf der Basis der Kombination von expandiertem Graphit und Kohlenstofffasern.
Damit ist die erstgenannte Aufgabe der vorliegenden Erfindung erfüllt.

Die zweite genannte Aufgabe, ein Verfahren zum Herstellen einer hochreinen ersetzbaren Verschleißeinlage aus expandiertem Graphit aufzuzeigen, erscheint trivial. Die Bildsamkeit von expandiertem Graphit ist außerordentlich gut, so dass es einfach erscheint, dünne, gut handhabbare Schichten, wo möglich in Form einer Zwischenlage oder eines Zwischentiegels - für den Einsatz zwischen Quarzglastiegel und Stütztiegel - zu fertigen. Diese außerordentlich gute Bildsamkeit des expandierten Graphites gilt jedoch nur für handelsübliche Materialtypen, deren Aschewert nach DIN 51903 von vier Prozent herunter bis zu 0,15 Prozent bzw. von 40.000 bis herunter zu 1.500 ppm reicht. Der Aschewert eines für die Halbleitertechnik einzusetzenden Graphitfolienmateriales sollte jedoch unter 500 ppm sein. Das bedeutet, dass das Graphitfolienmaterial nochmals gereinigt werden muss. Eine solche Reinigung gehört in der Graphittechnik zum Stand der Technik und findet oberhalb von 2000°C in einer ein Halogen enthaltenden oder in einer halogenhaltige Gase aufweisenden Atmosphäre statt.
Wenn ein Graphitfolienmaterial eine solche Reinigungsbehandlung erfahren hat, zeigt sich jedoch eine entscheidende Veränderung am Material: Es hat seine Bildsamkeit verloren und ist spröde geworden. Gibt man dieses gereinigte Material als dünne Folie in eine Form und versucht, die Folien durch vorsichtige Verformung der Kontur der Form anzupassen, so zerreißt das spröde Material. Es gelingt also nicht, dünne, zusammenhängende, gut handhabbare Schichten, wo möglich in Form einer konturierten Zwischenlage oder eines Zwischentiegels aus gereinigter Graphitfolie herzustellen.

Die Lösung der zweiten genannten Aufgabe dieser Erfindung gelingt durch die Anwendung des im Folgenden geschilderten erfindungsgemäßen Verfahrens:
Eine hochreine ersetzbare Verschleißeinlage aus expandiertem Graphit zum Schutze von graphitierten Stütztiegeln vor reaktivem Angriff durch Quarzglastiegel bei Prozessen der Halbleitertechnik mit Temperaturen über 500 °C wird mit folgenden Schritten hergestellt:
   - In einem ersten Schritt wird der expandierte Graphit in eine aus mindestens zwei Teilen - in der Regel einem Oberund einem Unterstempel - bestehende Pressform ausreichender Stabilität gegeben,
   - in einem zweiten Schritt wird die Form mit einem Druck von mindestens 10 MPa und höchstens 100 MPa geschlossen und somit der expandierte Graphit beim Schließen verdichtet und geformt,
   - in einem dritten Schritt wird das verdichtete und geformte Teil aus expandiertem Graphit aus der Form entnommen und in eine Form gleicher Geometrie der formenden Flächen aus temperaturfestem Material, z.B. Elektrographit oder kohlenstofffaser-verstärkter Kohlenstoff, gegeben,
   - in einem vierten Schritt wird die Form aus temperaturfestem Material, z.B. Elektrographit oder kohlenstofffaser-verstärkter Kohlenstoff, mit dem darin enthaltenen, verdichteten und geformten Teil aus expandiertem Graphit bei Temperaturen oberhalb von 2000 °C in einer ein Halogen enthaltenden oder in einer halogenhaltige Gase aufweisenden Atmosphäre gereinigt und
   - in einem fünften Schritt wird das so hergestellte, verdichtete, geformte, gereinigte und nun spröde Teil aus expandiertem Graphit aus der Form entnommen und als Verschleißeinlage seinem Verwendungszweck zugeführt.

Unter bestimmten Bedingungen kann das Verfahren dann vereinfacht werden, wenn nur geringe Pressdrücke zur Verdichtung des expandierten Graphites benötigt werden, wenn er z.B. in einer besonders niedrigen Rohdichte vorliegt und die benötigten Pressdrücke die eingesetzte graphitierte Form nicht zerstören bzw. wenn bei stärkerer notwendiger Verdichtung eine hochfeste Pressform aus CFC zur Verfügung steht. Dann wird eine hochreine' ersetzbare Verschleißeinlage aus expandiertem Graphit zum Schutze von graphitierten Stütztiegeln vor reaktivem Angriff durch Quarzglastiegel bei Prozessen der Halbleitertechnik mit Temperaturen über 500 °C mit folgenden erfindungsgemäßen Schritten hergestellt:
- In einem ersten Schritt wird der expandierte Graphit in eine aus mindestens zwei Teilen - in der Regel einem Oberund einem Unterstempel - bestehende temperaturfeste Pressform aus z.B. Elektrographit oder kohlenstofffaser-verstärktem Kohlenstoff gegeben,
- in einem zweiten Schritt wird die Form mit einem Druck von mindestens 10 MPa und höchstens 100 MPa geschlossen und somit der expandierte Graphit beim Schließen verdichtet und geformt,
- in einem dritten Schritt wird die Form aus temperaturfestem Material, z.B. Elektrographit oder kohlenstofffaser-verstärkter Kohlenstoff, mit dem darin enthaltenen, verdichteten und geformten Teil aus expandiertem Graphit bei Temperaturen oberhalb von 2000 °C in einer ein Halogen enthaltenden oder in einer halogenhaltige Gase aufweisenden Atmosphäre gereinigt und
- in einem vierten Schritt wird das so hergestellte, verdichtete, geformte, gereinigte und nun spröde Teil aus expandiertem Graphit ohne oder mit Additiven aus der Form entnommen und als Verschleißeinlage seinem Verwendungszweck zugeführt.

In die hier beschriebenen alternativen Verfahren wird expandierter Graphit vorwiegend in Form von Folien oder Folienzuschnitten eingesetzt. Da die Pressform Teilflächen aufweist, die vorzugsweise senkrecht zur Pressrichtung orientiert sind, andererseits Teilflächen vorhanden sind, die nahezu parallel zur Pressrichtung orientiert sind, herrschen beim Schließen der Pressform auf den verschiedenen Teilflächen verschiedene Pressdrücke. Der eingesetzte expandierte Graphit wird in der Folge unterschiedlich verdichtet und erhält damit unterschiedliche Festigkeiten an der jeweiligen Teilfläche der herzustellenden hochreinen ersetzbaren Verschleißeinlage. Um dem zu begegnen, ist es mitunter sinnvoll, die verschiedenen Teilflächen der Pressform mit verschieden stark vorverdichteten Folien oder Folienzuschnitten zu belegen.
Sollten die Folien an einigen Stellen der herzustellenden hochreinen ersetzbaren Verschleißeinlage nicht ausreichen, so besteht die Möglichkeit die Materialmenge in der Pressform durch Flocken aus expandiertem Graphit mit sehr niedriger Schüttdichte zu ergänzen.

In diesen Fällen verwendet man also zwei oder sogar mehrere Einsatzstoffe der selben Materialklasse jedoch mit unterschiedlichen Rohdichten.
Es ist möglich, die Form nur mit Flocken aus expandiertem Graphit zu füllen.

Als Ergebnis der erstgenannten Aufgabe der vorliegenden Erfindung wurden zwei Werkstoffgruppen genannt, die die Anforderungen erfüllen. Neben der zweiten Gruppe, den Werkstoffen auf der Basis von expandiertem Graphit, wird die dritte Gruppe, nämlich Werkstoffe auf der Basis der Kombination von Kohlenstofffasern und expandiertem Graphit, genannt. Werkstoffe auf der Basis der Kombination von Kohlenstofffasern und expandiertem Graphit sind ebenfalls geeignet, nach den beiden oben beschriebenen Verfahren mit fünf bzw. vier Schritten verarbeitet zu werden.

In diesen Fällen verwendet man zwei verschiedene Materialklassen (expandierten Graphit und Kohlenstofffasern), wobei jede Materialklasse mehrere Einsatzstoffe mit unterschiedlicher Ausprägung (z.B. Rohdichten des expandierten Graphites oder Art der textilen Aufmachung der Fasern) aufweisen kann.

Die zur Verdichtung des expandierten Graphites - und bei Bedarf anteilig mit Kohlenstofffasern versetzten expandierten Graphites - eingesetzten Formen bestehen in der Regel aus einem Oberstempel und einem Unterstempel. Bei geschlossener Gesamtform sind die beiden Stempel durch einen Spalt von im wesentlichen gleicher Breite getrennt. Ein in der Gesamtform gepresstes Teil, welches nach Durchlaufen des gesamten Prozesses als Verschleißeinlage genutzt werden soll, weist also im wesentlichen eine Wandstärke gleichmäßiger Dicke auf. Es können jedoch besondere Anforderungen an die Stabilität und die Handhabbarkeit der ersetzbaren Verschleißeinlage gestellt werden, die partielle Aufdickungen der Wandstärke der Verschleißeinlage verlangen. Dann ist der Spalt zwischen Oberstempel und Unterstempel bei geschlossener Gesamtform partiell zu vergrößern. Entsprechend der gewünschten Geometrie der ersetzbaren Verschleißeinlage ist die formgebende Oberfläche des einen Stempels im wesentlichen konvex und die formgebende Oberfläche des anderen Stempels im wesentlichen konkav. Die konvexe Form des einen Stempels entspricht der äußeren Oberfläche des Quarzglastiegels.

Zur Herstellung einer hochreinen ersetzbaren Verschleißeinlage wird das Material von mindestens einer Materialklasse verwendet, um damit die formende Oberfläche des Unterstempels der Gesamtform zu bedecken. Wie erläutert, können alternativ verschiedene Einsatzstoffe derselben Materialklasse oder sogar verschiedene Materialklassen bestehend aus mehreren Einsatzstoffen verwendet werden. Die Bedeckung der formenden Oberfläche des Unterstempels ist geschlossen, das heißt, Lücken zwischen den Materialabschnitten sind zu vermeiden.
Die formende Oberfläche des Unterstempels wird in jedem Falle zu mehr als 90 % bedeckt. Ein Quarzglastiegel für den Czochralski-Prozess ist während des Prozesses nicht vollständig mit Siliciumschmelze gefüllt, weshalb der obere Rand des Quarzglastiegels nicht durch den Flüssigkeitsdruck der Schmelze belastet wird. Folglich ist es nicht nötig, diesen oberen Rand durch einen Graphittiegel zu stützen.

Die hochreine ersetzbare Verschleißeinlage deckt den oberen Rand des Quarzglastiegels nicht ab.

Gemäß den oben beschriebenen Verfahren wird das gepresste Teil in einer graphitierten Form ruhend gereinigt. Dazu wird die Form mit dem gepressten Teil bis zu mehr als 2000°C in einer ein Halogen enthaltenden oder in einer halogenhaltige Gase aufweisenden Atmosphäre aufgeheizt und eine Zeit lang bei dieser Temperatur belassen. Der Aschewert der Form und des gepressten Teiles beträgt nach der Behandlung weniger als 500 ppm.

Die Vorteile der Herstellung und Verwendung von hochreinen ersetzbaren Verschleißeinlagen können wie folgt zusammengefasst werden:
- Bisher wurde über einen vieljährigen Zeitraum eine Kette von Graphiten für graphitierte Stütztiegel von Quarzglastiegeln in Czochralski-Prozessen entwickelt, wobei die Qualität dieser Graphite bezüglich Festigkeit und Oxidationsbeständigkeit immer weiter gesteigert wurde. Eine Steigerung der Materialeigenschaften konnte von Mal zu Mal nur mit steigendem Aufwand erreicht werden. Diese Fortentwicklung ist nun nicht mehr notwendig.
- Im Gegenteil: Da mit der zwischen Quarzglastiegel und graphitiertem Stütztiegel einfügbaren hochreinen ersetzbaren Verschleißeinlage die Wanderung der Zersetzungsprodukte des Quarzglastiegels zum graphitierten Stütztiegel hin weitgehend unterbunden wird und praktisch kein reaktiver Angriff des Stütztiegels erfolgt, können preiswertere Graphitqualitäten zum Herstellen der Stütztiegel verwendet werden.

Durch die folgenden Figuren wird die Erfindung beispielhaft weiter erläutert. Es zeigen:
- Fig. 1: Eine Ronde 1 aus einer Folie aus expandiertem Graphit mit Einschnitten 2 in der Draufsicht,
- Fig. 2a: Schnitt durch den Oberstempel 4 einer Pressform,
- Fig. 2b: Schnitt durch den Unterstempel 3 einer Pressform,
- Fig. 3a: Schnitt durch das Oberteil 6 einer Form aus temperaturfestem Material für den Reinigungsschritt
- Fig. 3b: Schnitt durch das Unterteil 5 einer Form aus temperaturfestem Material für den Reinigungsschritt und
- Fig. 4: Schnitt durch den Deckel 8 und den Boden 7 der Verpackungseinheit; dazwischen ist eine idealisierte Verschleißeinlage 9 im Schnitt eingezeichnet.

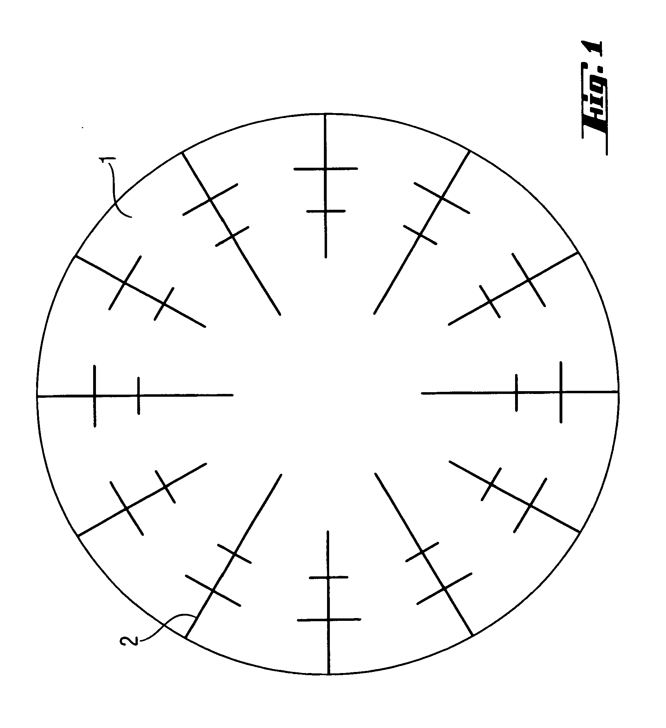

In Fig. 1 wird ein homogenes Material gezeigt, welches nach dem Einschneiden von Mustern aus radialen und tangentialen Schnitten 2 geeignet ist, eine geschlossene Schicht in eine konturierte Form zu legen.

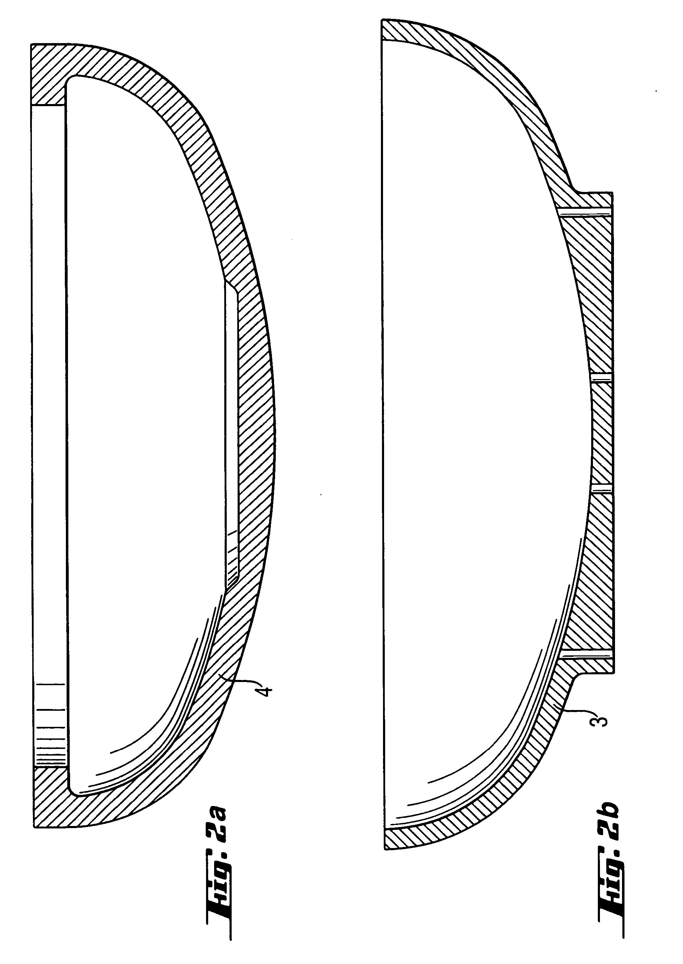

Eine Pressform ist aus einem gut bearbeitbaren Material herzustellen, welches die notwendigen Form- oder Schließkräfte aufnehmen kann. Das Material der Form kann so gewählt sein, dass es eine Hochtemperaturbehandlung von mehr als 2000 °C aushält, es muss dieses Kriterium aber nicht erfüllen. Zweckmäßigerweise wird die Pressform aus einem Oberstempel 4, Fig. 2a, und einem Unterstempel 3, Fig. 2b, zusammengesetzt. Die Form muß geeignet sein, expandierten Graphit mit Additiven je nach vorgegebenen Materialtypen zu formen und/oder zu verdichten.

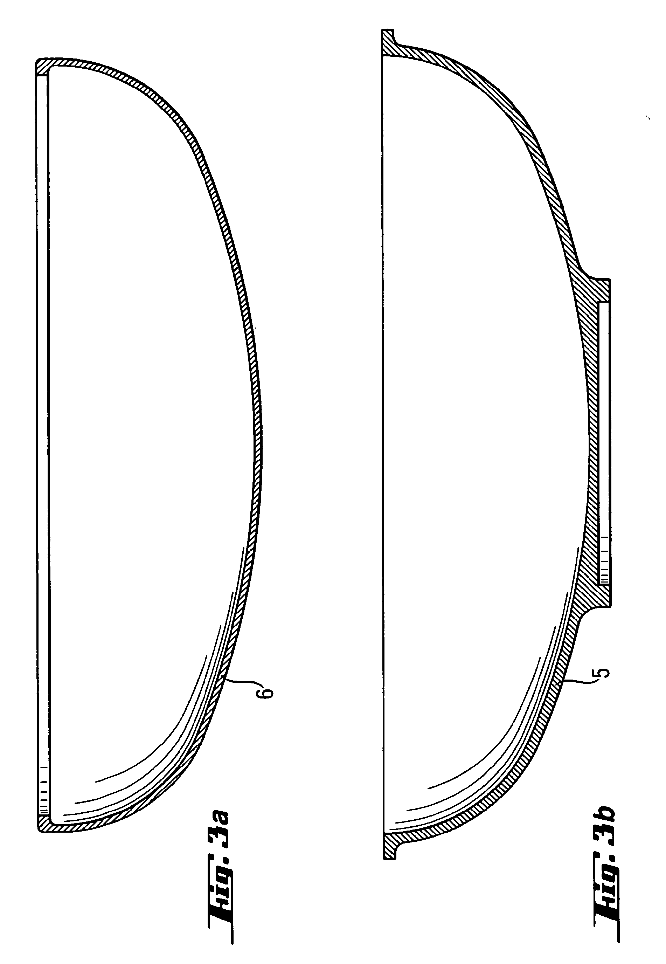

Die Form aus Oberteil 6 , Fig. 3a, und Unterteil 5, Fig. 3b, hat nicht die Aufgabe, eine Kontur auf das Rohmaterial aufzuprägen sondern die mit der Pressform gegebene Kontur eines Teiles aus expandiertem Graphit und seinen Additiven bei dem Hochtemperaturprozess der Reinigung zu erhalten. Die Form muss also hoch temperaturfest sein.
Eine zweite Aufgabe besteht darin, möglichst wenig Verunreinigungen in den Reinigungsprozess einzubringen. Diese Aufgabe wird dann gut erfüllt, wenn die Form selbst hochrein, dünnwandig und massearm ist.

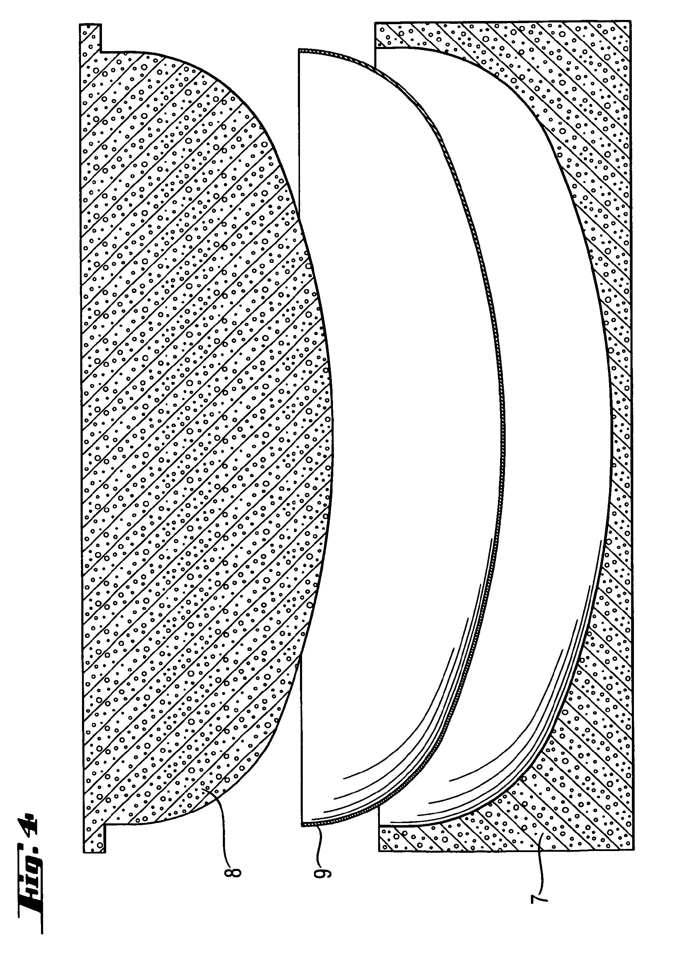

Die im Schnitt in Fig. 4 dargestellte Verpackungseinheit 7, 8 erfüllt zwei Aufgaben:
1. Sie schützt die sehr weiche und leicht zu knitternde Verschleißeinlage bei Transport und Lagerung vor mechanischer Beschädigung.
2. Sie schützt die hochreine Verschleißeinlage bei Transport und Lagerung vor Verunreinigung.
   Ergänzend ist zwischen Deckel 8 und Boden 7 eine idealisierte Verschleißeinlage 9 im Schnitt eingezeichnet.

Die Herstellbarkeit einer erfindungsgemäßen Verschleißeinlage wird durch ein Ausführungsbeispiel gezeigt: Es wurde eine kommerziell als Rollenware angebotene Folie aus expandiertem Graphit, z.B. ®SIGRAFLEX F02510Z, SGL CARBON AG, D-86405 Meitingen, Deutschland, in einer Dicke von 0,25 mm eingesetzt. Das Material war für einen Tiegel von 28 Zoll Durchmesser vorgesehen, wobei der graphitierte Stütztiegel im zylindrischen Teil einen lichten Durchmesser von 28 Zoll aufwies und der darin einzusetzende Quarzglastiegel einen etwa 1 mm geringeren Außendurchmesser hatte. Aus der Folie aus expandiertem Graphit wurde eine Ronde 1 von 920 mm Durchmesser ausgeschnitten. Mit Messern und mit Hilfe einer Schablone wurde von Hand ein Muster von radialen und tangentialen Schnitten 2 in die Ronde 1 eingebracht, s. Fig.1.
Die so vorbereitete Ronde 1 aus expandiertem Graphit wurde in den unteren Teil einer Pressform (Unterstempel) 3 eingelegt, s. Fig. 2b. Die Schnitte in der Ronde 1 gestatteten es, die Folie aus expandiertem Graphit praktisch faltenfrei in den Unterstempel 3 einzulegen, allerdings überlappten Teile der Folie, insbesondere an der Peripherie der Form. Andererseits wurde mit dem Zuschnitt der Ronde 1 und der Ablage der Ronde 1 im Unterstempel 3 gesichert, dass der expandierte Graphit eine geschlossene Lage bildete und keine Spalten zwischen Teilen der Graphitfolie vorlagen. Mit dem Oberstempel 4 der Pressform wurde die Gesamtform geschlossen und der eingelegte expandierte Graphit geformt. Die durch den Oberstempel 4 ausgeübte Gesamtschließkraft betrug ca. 2000 N.
Der Formwerkstoff war isostatisch verdichteter Graphit, die Wandstärke der Form betrug etwa 20 mm, was für die oben genannte Gesamtschließkraft ausreichte.
Nach dem Öffnen der Form wurde der geformte expandierte Graphit als zusammenhängende Einheit von Hand aus der Pressunterform entnommen und in das wesentlich dünnwandigere Unterteil einer Graphitform 5 gelegt, die für den Prozessschritt der Reinigung vorgesehen war. Mit Hilfe des ebenfalls sehr dünnwandigen Oberteils 6 wurde diese zweite Form ohne Anwendung eines zusätzlichen Druckes geschlossen. Die formgebenden Konturen von Pressform und Reinigungsform waren identisch.
Die zweite Form (Reinigungsform) hatte die Aufgabe, die geformte zusammenhängende Einheit aus expandiertem Graphit in der gewünschten Kontur zu stabilisieren und so durch den bei oberhalb von 2000°C ablaufenden Reinigungsprozess zu bringen. Die geringe Wandstärke dieser Form war dadurch bedingt, dass mit der dünnwandigen Form
1. möglichst wenig (Form-)Masse aufgeheizt werden musste und
2. mit dem Material der Form möglichst wenig Verunreinigungen in den Reinigungsprozess eingebracht wurden.
   Nach dem Reinigungsprozess wurde die geformte zusammenhängende Einheit aus expandiertem Graphit aus der Reinigungsform entnommen. Das Teil aus expandiertem Graphit konnte nun als "Verschleißeinlage" 9 für den Czochralski-Prozess bezeichnet werden.
   Von Hand wurde sie unter Beachtung äußerster Reinlichkeit in eine aus Schaumstoff bestehende Verpackungseinheit gegeben, die wiederum die gleichen Konturen aufwies wie die Pressform und die Reinigungsform. Damit die Verpackungseinheit aus Boden 7 und Deckel 8 insbesondere in den Schaumbläschen keine Verunreinigung aus der Umgebung aufnahm, wurden die Oberflächen der Schaumstoffteile mit einer Polyethylenfolie beschichtet.

### Bezugszeichenliste

- 1: Ronde aus expandiertem Graphit
- 2: Muster aus radialen und tangentialen Schnitten
- 3: Unterstempel der Preßform
- 4: Oberstempel der Preßform
- 5: Dünnwandiges Unterteil einer Reinigungsform
- 6: Dünnwandiges Oberteil einer Reinigungsform
- 7: Boden einer Verpackungseinheit aus Schaumstoff
- 8: Deckel einer Verpackungseinheit aus Schaumstoff
- 9: Idealisierte Verschleißeinlage, vereinfachend auch "Teil" genannt

## Patentansprüche

1. Verfahren zum Herstellen einer hochreinen ersetzbaren Verschleißeinlage (9) aus expandiertem Graphit zum Schutze von graphitierten Stütztiegeln vor oxidativem Angriff durch Quarzglastiegel bei Prozessen der Halbleitertechnik mit Temperaturen über 500°C,
bei dem
der expandierte Graphit in eine aus mindestens zwei Teilen (3), (4) bestehende Pressform gegeben wird,
die Pressform mit einem Druck von 10 bis 100 MPa geschlossen wird,
das verdichtete und geformte Teil aus der Form entnommen und in eine Form aus temperaturfestem Material (5), (6) und mit gleicher Geometrie der formenden Flächen gebracht wird und
in dieser Form (5), (6) eine Behandlung oberhalb von 2000°C in einer halogenhaltigen Atmosphäre erfolgt, wobei das Teil (9) gereinigt und versprödet wird.

2. Verfahren zum Herstellen einer hochreinen ersetzbaren Verschleißeinlage (9) aus expandiertem Graphit zum Schutze von graphitierten Stütztiegeln vor oxidativem Angriff durch Quarzglastiegel bei Prozessen der Halbleitertechnik mit Temperaturen über 500°C,
bei dem
der expandierte Graphit in eine aus mindestens zwei Teilen bestehende Pressform aus temperaturfestem Material (5), (6) gegeben wird,
die Pressform mit einem Druck von 10 bis 100 MPa geschlossen wird und
anschließend das verdichtete und geformte Teil in dieser Form einer Behandlung in einer halogenhaltigen Atmosphäre oberhalb von 2000°C unterzogen wird, wobei das Teil (9) gereinigt und versprödet wird.

3. Verfahren nach Ansprüchen 1 oder 2, **dadurch**
**gekennzeichnet, dass**
die formgebenden Oberflächen des Oberstempels und des Unterstempels bei geschlossener Gesamtform durch einen Spalt von im wesentlichen gleicher Breite getrennt sind, wobei die formgebende Oberfläche des einen Stempels im wesentlichen konvex und die formgebende Oberfläche des anderen Stempels im wesentlichen konkav ist.

4. Verfahren nach Ansprüchen 1 bis 3, **dadurch**
**gekennzeichnet, dass**
die Geometrie des konvexen Stempels der Geometrie der äußeren Oberfläche des Quarzglastiegels entspricht, für den die Verschleißeinlage (9) vorgesehen ist.

5. Verfahren nach Ansprüchen 1 bis 4, **dadurch**
**gekennzeichnet, dass**
der expandierte Graphit in Form von Folie, in Form von Folienzusschnitten, in Form von Flocken, als Kombination von mindestens zwei dieser Formen
oder dass der expandierte Graphit in Kombination mit Additiven wie textilen Formen von Kohlenstofffaserprodukten zum Bedecken der Formoberflächen verwendet wird.

6. Verfahren nach Ansprüchen 1 bis 5, **dadurch**
**gekennzeichnet, dass**
der expandierte Graphit ohne oder mit Additiven nach dem Ablegen auf dem Unterstempel (3) der Form die formgebende Oberfläche dieses Unterstempels zu mehr als 90% bedeckt.

7. Ersetzbare Verschleißeinlage (9) aus expandiertem Graphit, herstellbar nach den Ansprüchen 1 bis 6,
**dadurch gekennzeichnet, dass**
sie weniger als 500 ppm Aschebestandteile enthält.

8. Verwendung einer Verschleißeinlage (9) nach Anspruch 7 zum Schutze von graphitierten Stütztiegeln vor oxidativem Angriff durch Quarzglastiegel bei Prozessen der Halbleitertechnik mit Temperaturen über 500°C, wobei die Verschleißeinlage (9) den Quarzglastiegel nicht völlig bedeckt.

## Claims

1. Method for producing a high purity, replaceable wear-resistant inlay (9) from expanded graphite for protecting graphitized support crucibles against oxidative attack by quartz glass crucibles in semiconductor technology processes at temperatures above 500°C,
in which method
the expanded graphite is placed into a press mould consisting of at least two parts (3), (4),
the press mould is closed with a pressure of 10 to 100 MPa,
the compressed and moulded part is removed from the mould and placed into a mould made of temperature-resistant material (5), (6) and having an identical geometry of the moulding surfaces, and,
in this mould (5), (6), treatment is effected above 2000°C in a halogen-containing atmosphere, with the part (9) being purified and embrittled.

2. Method for producing a high purity, replaceable wear-resistant inlay (9) from expanded graphite for protecting graphitized support crucibles against oxidative attack by quartz glass crucibles in semiconductor technology processes at temperatures above 500°C,
in which method
the expanded graphite is placed into a press mould which consists of at least two parts and is made of temperature-resistant material (5), (6),
the press mould is closed with a pressure of 10 to 100 MPa, and
then the compressed and moulded part is subjected in this mould to treatment in a halogen-containing atmosphere above 2000°C, with the part (9) being purified and embrittled.

3. Method according to Claim 1 or 2, **characterized in that**
the shaping surfaces of the upper punch and of the lower punch are separated by a gap of substantially identical width when the overall mould is closed, wherein the shaping surface of one punch is substantially convex and the shaping surface of the other punch is substantially concave.

4. Method according to Claims 1 to 3, **characterized in that**
the geometry of the convex punch corresponds to the geometry of the outer surface of the quartz glass crucible for which the wear-resistant inlay (9) is provided.

5. Method according to Claims 1 to 4, **characterized in that**
the expanded graphite is used in the form of foil, in the form of foil blanks, in the form of flakes, as a combination of at least two of these forms, or **in that** the expanded graphite is used in combination with additives such as textile forms of carbon fibre products for covering the mould surfaces.

6. Method according to Claims 1 to 5, **characterized in that**,
after it has been deposited on the lower punch (3) of the mould, the expanded graphite covers the shaping surface of said lower punch to an extent of more than 90% without or with additives.

7. Replaceable wear-resistant inlay (9) made of expanded graphite, producible according to Claims 1 to 6,
**characterized in that**
it contains less than 500 ppm of ash constituents.

8. Use of a wear-resistant inlay (9) according to Claim 7 for protecting graphitized support crucibles against oxidative attack by quartz glass crucibles in semiconductor technology processes at temperatures above 500°C, wherein the wear-resistant inlay (9) does not cover the quartz glass crucible completely.

## Revendications

1. Procédé de fabrication d'une garniture d'usure (9) à haute pureté, remplaçable, en graphite expansé, pour protéger des creusets graphités de soutien vis-à-vis d'une attaque oxydante par des creusets en verre de quartz dans des procédés de la technique des semi-conducteurs à des températures supérieures à 500°C, dans lequel
le graphite expansé est délivré dans un moule de compression constitué d'au moins deux parties (3), (4), le moule de compression étant fermé sous une pression de 10 à 100 MPa,
la pièce comprimée moulée est retirée du moule et est amenée dans un moule en matériau réfractaire (5), (6) qui présente la même géométrie que les surfaces à mouler et
dans ce moule (5), (6) a lieu un traitement à une température supérieure à 2 000°C dans une atmosphère contenant des halogènes, la pièce (9) étant nettoyée et fragilisée.

2. Procédé de fabrication d'une garniture d'usure (9) à haute pureté, remplaçable, en graphite expansé, pour protéger des creusets graphités de soutien vis-à-vis d'une attaque oxydante par des creusets en verre de quartz dans des procédés de la technique des semi-conducteurs à des températures supérieures à 500°C, dans lequel
le graphite expansé est délivré dans un moule de compression en matériau réfractaire (5), (6),
le moule de compression est fermé sous une pression de 10 à 100 MPa et
la pièce comprimée et moulée est ensuite exposée dans ce moule à un traitement à une température supérieure à 2 000°C dans une atmosphère contenant des halogènes, la pièce (9) étant nettoyée et fragilisée.

3. Procédé selon la revendication 1 ou 2, **caractérisé en ce que** les surfaces de moulage du poussoir supérieur et du poussoir inférieur sont séparées par un interstice de largeur essentiellement uniforme lorsque le moule total est fermé, la surface de moulage d'un des poussoirs étant essentiellement convexe et la surface de moulage de l'autre poussoir essentiellement concave.

4. Procédé selon les revendications 1 à 3, **caractérisé en ce que** la géométrie du poussoir convexe correspond à la géométrie de la surface extérieure du creuset en verre de quartz pour lequel la garniture d'usure (9) est prévue.

5. Procédé selon les revendications 1 à 4, **caractérisé en ce que** le graphite expansé est utilisé sous la forme d'un film, sous la forme de flans de film, sous la forme de flocons, en combinaison d'au moins deux de ces formes ou **en ce que** le graphite expansé est utilisé en combinaison avec des additifs, par exemple des formes textiles de produits en fibres de carbone destinés à recouvrir les surfaces du moule.

6. Procédé selon les revendications 1 à 5, **caractérisé en ce qu'**après avoir été placé sur le poussoir inférieur (3) du moule, le graphite expansé recouvre seul ou avec les additifs plus de 90 % de la surface de moulage de ce poussoir inférieur.

7. Garniture d'usure (9) remplaçable en graphite expansé fabriquée selon les revendications 1 à 6 et **caractérisée en ce qu'**elle contient moins de 500 ppm de cendres.

8. Utilisation d'une garniture d'usure (9) selon la revendication 7 pour la protection de creusets graphités de soutien vis-à-vis d'une attaque oxydante par des creusets en verre de quartz dans des procédés de la technique des semi-conducteurs à des températures supérieures à 500°C, la garniture d'usure (9) ne recouvrant pas complètement le creuset en verre de quartz.
